# EUROPEAN PATENT SPECIFICATION

(11) **EP 1 466 997 B1**
(45) Date of publication and mention of the grant of the patent: **22.02.2012**
(21) Application number: 03005270.8
(22) Date of filing: 10.03.2003
(51) Int. Cl.: C23C 14/08, B32B 27/00

(54) **Method for forming and arrangement of barrier layers on a polymeric substrate**
Verfahren zur Herstellung und Anordnung von Barriereschichten auf einem Polymersubstrat
Procédé de préparation et d'arrangement des couches barrières sur un substrat polymère

(43) Date of publication of application: 13.10.2004
(73) Proprietor: OSRAM Opto Semiconductors GmbH, 93055 Regensburg (DE)
(72) Inventor: Pätzold, Ralph, 91154 Roth (DE); Gieres, Günter, 91077 Kleinsendelbach (DE); Wittmann, Georg, 91074 Herzogenaurach (DE); Henseler, Debora, 91052 Erlangen (DE); Heuser, Karsten, 91056 Erlangen (DE)
(74) Representative: Epping - Hermann - Fischer

(56) References cited:
- EP-A- 0 727 505
- US-A- 5 792 550
- US-B1- 6 413 645

## Description

A lot of products, for example food, electronical devices or pharmaceuticals are very sensitive to moisture and oxidising agents. Many of these products rapidly degrade when exposed to water, oxidising agents or other gases or liquids. Polymeric substrates like polymeric foils are often used to package these products. These foils frequently exhibit a permeability for water vapor and for oxidising agents in the range of more than 1g/(m² day). This high degree of permeability is unacceptable for most of the products packaged by polymer foils.

One major field of application for packaging by polymeric substances are organic electroluminescent devices (OLEDs). An OLED device comprises a functional stack formed on a substrate. The functional stack comprises at least one or more organic functional layers sandwiched between two conductive layers. The conductive layers serve as electrodes (cathode and anode). When a voltage is applied to the electrodes, charge carriers are injected through these electrodes into the functional layers and upon recombination of the charge carriers visible radiation can be emitted (electroluminescence). This functional stack of the OLED is very sensitive to moisture and oxidising agents, which can cause e.g. oxidation of the metals of the electrodes or deterioration of the organic functional layers. The next generation of these organic light emitting devices, which will be arranged on flexible substrates, like polymeric substrates, are under current investigation. For a sufficient lifetime of the OLEDs polymeric substrates with a permeability for water or oxidising agents below 10⁻⁶g/ (m² day) are needed.

The patent application WO 00/48749 A1 describes a method to reinforce polymeric foils by reinforcing them with thin ceramic layers in order to block out gases or liquids more efficiently. Ceramic layers frequently have defects in their microstructures which can serve as a continuous path for gases and water vapor for passing through the ceramic layers. These defects lead to a decreased ability of the ceramic layers to serve as a barrier. In this context all pathways through the inorganic, ceramic barrier layers are called defects. Defects in the context of this invention are among others pinholes, grain boundaries, shadowing effects and impurities.

The publication WO 01/81649 A1 describes a method of depositing several thin ceramic layers on top of each other on polymeric substrates in order to enhance the barrier abilities of the polymeric substrates. This publication presents the possibility to decouple defects in successive ceramic layers by changing the deposition parameters and growth conditions for the deposition of the ceramic layers. According to the publication this method should lead to mismatched subsequent barrier layers, which exhibit different microstructures and therefore enhance the path for gases and water vapor permeation, leading to enhanced barrier abilities. Experiments carried out by the inventors indicate that ceramic barrier stacks produced by this method exhibit enhanced barrier abilities, but show no major improvements, when defects larger than grain boundaries e.g. pinholes or shadowing effects are present.

Therefore, there is a need for polymeric substrates with improved barrier abilities. The present invention meets these needs by providing a method for forming an arrangement of barrier layers on a polymeric substrate according to the base claim 1. Favourable embodiments of the invention and a method for forming an OLED are subject of further dependent claims.

The main subject of the invention according to the base claim is a method for forming an arrangement of two ceramic barrier layers on a polymeric substrate which comprises the following subsequent steps:
A) Applying a first barrier layer on the substrate,
B) modifying the surface of the first barrier layer to introduce new nucleation sites on the surface of this first layer, and
C) forming a second ceramic barrier layer on the first barrier layer using the new nucleation sites.

In contrast to the conventional methods the method of the invention modifies in step B) the surface of the first barrier layer in order to introduce new nucleation sites on the surface of this layer. These new nucleation sites serve as a starting point for the formation of the second ceramic barrier layer in step C). Therefore due to thermodynamics the second ceramic barrier layers can be formed on the first barrier layers without continuing all the defects, pinholes and grains of the first layer throughout the second or any following barrier layer. The method of the invention therefore allows the growth of at least two thermodynamically decoupled layers on top of each other with independent nucleation for every single layer.

The method of the invention therefore changes the grain boundaries on the surface of the first ceramic barrier layer because these grain boundaries will be reproduced for thermodynamical reasons in the second layer, if no new nucleation is introduced and will also form the preferred path where water and oxidising agents can travel through the ceramic barrier layers. Introducing new nucleation sites ensures that the second layer can be formed on the first ceramic layer independent from the morphology and the energetic conditions of the first layer. The nucleation depends sensitively on the kinetic energy and mobility of the molecules on the surface of layer on atomic scale.

Therefore an arrangement of at least two ceramic barrier layers on a polymeric substrate formed by the method of the invention is less permeable for gases and liquids than barrier stacks produced by conventional methods.

The introduction of new nucleation sites on the surface of the first layer in step B) can be performed by chemical surface modification, mechanical surface modification or by the application of nucleation-promoting material on the surface of the first layer. The chemical surface modification can be performed by saturating "dangling", unsaturated bonds on the surface of the first layer or changing the lattice parameters of the surface of the first layer by e.g. oxidation. The chemical surface modification can further comprise acid treatment, base treatment, exposure to water vapor, plasma treatment or ozone treatment. These modification methods can change and introduce new nucleation sites on the surface of the first layer very efficiently.

The mechanical surface modification can comprise ion-milling, nano-grinding, melting of the surface by a laser-beam or tempering. During the ion-milling the surface of the first barrier layer can be treated with ion beams, for example argon ion beams or oxygen ion beams in order to change the topology of the surface. During nano-grinding the surface of the first barrier layer can be polished using abrasive particles of nanometer size. Tempering comprises curing the first layer by applying temperatures higher than temperatures applied during the formation of this layer in order to initiate at least a partial rearrangement of the crystal lattice of the surface of this layer. Melting of the surface by a laser-beam involves the melting of surface areas of the first ceramic layer in order to allow a rearrangement of the crystal lattice as well.

The surface of the first ceramic layer can also be doped with nucleation promoting materials during step B). This material is preferably selected from a group of metals, metal nitrides and metal oxides wherein the material has a small critical nucleus, which can be one atom or molecule in the best case. The critical nucleus denotes the minimal number of atoms or molecules forming a stable grain. The nucleation promoting materials are favourably selected from the following materials: tantalum, chromium, tungsten, molybdenum, niobium, titanium, tantalum-nitride, titanium-nitride, tantalum-oxide and titanium-oxide. These materials are well able to serve as nucleation sites for the growth of the second ceramic barrier layer. The nucleation promoting materials do not have to build up a continuos layer on the surface of the first ceramic barrier layer. The deposited amount of nucleation promoting material on the surface of the first layer can be clearly below the mass needed to create on monomolecular layer, so that the surface of the first ceramic layer is only "doped" with the nucleation promoting material.

In an advantageous embodiment of the method of the invention a ceramic material for the first and second barrier layer is used, which is selected from metal nitrides, metal oxides or metal oxynitrides. The metals for these metal nitrides, metal oxides or metal oxynitrides are preferably selected from aluminium or silicon. These ceramic materials are well able to serve as barrier layers in order to block out gases or liquids. Apart from these materials other ceramic materials, which comprise predominately inorganic and non-metallic compounds or elements can be used.

In step C) the second ceramic barrier layer is preferably formed by chemical vapor deposition (CVD) or physical vapor deposition (PVD). These methods are preferably used to deposit ceramic layers of high quality on substrates.

Preferably a flexible, transparent substrate e.g. polyethyleneterepthalate (PET) is used in the method of the invention. Flexible, transparent substrates are the preferred substrates for organo-optical devices like the above-mentioned OLEDs, because e.g. these substrates are transparent for the light emitted by the OLEDs.

It is also possible to deposit at least one third ceramic barrier layer on the surface of the second ceramic barrier layer by repeating the steps B) and C) of the method of the invention. In this embodiment the surface of the second ceramic layer is also modified in order to introduce new nucleation sites. These new nucleation sites could afterwards serve as starting points for the deposition of the third ceramic barrier layer. An arrangement with three or more ceramic barrier layers can be used for applications where an extremely low permeation rate of the substrate for gases and liquids is necessary.

In the steps A) and C) the first and second barrier layers can be formed in a thickness of 1 to 250 nm preferably in a thickness of 10 to 100 nm. Such layers can be used as barrier layers, for example for transparent substrates for flexible OLED devices, because the light emitted by the OLED can still pass through these barrier layers.

The arrangement of the ceramic barrier layers on the polymeric substrate produced by the method of the invention can be used to build up organic electrical devices like integrated plastic circuits or flexible organic light sensors like organic solar cells or photodetectors. Therefore it is possible to form an organic, functional layer after step C) on the top barrier layer. In this embodiment of the invention the arrangement of the substrate and the ceramic layers can serve as a barrier stack to protect the sensitive organic functional layer from moisture or oxidising agents.

In another favourable embodiment the method of the invention further comprises subsequent steps to form an OLED wherein in step D) a first electrically conductive layer is formed on the second barrier layer after step C), and in step E) a functional, organic layer is formed on the first electrically conductive layer and in step F) a second electrically conductive layer is formed on the functional, organic layer. The conductive layers, which for example can comprise Indium-tin-oxide (ITO) can easily be patterned, e.g. to form stripes. The first electrically conductive layer could be patterned into a plurality of parallel electrode stripes, whereas the second electrically conductive layer can also be formed into a plurality of parallel electrode stripes running perpendicular to the electrode stripes of the first conductive layer. The crossing points between the electrode stripes/of the first and of the second layer can form the pixels of the OLED device.

Furthermore it is possible to form an encapsulation during an additional step G) over an OLED device which was built up on an barrier arrangement formed by an method of the invention. This step G) can further comprise a step G1), where a fourth ceramic barrier layer is formed over the second electrically conductive layer of the OLED device and during a step G2) the surface of the fourth barrier layer is subsequently modified to introduce new nucleation sites on the surface of this fourth layer. Afterwards a fifth ceramic barrier layer is formed during step G3) on the fourth ceramic barrier layer. By means of this favorable embodiment of the method of the invention a complete encapsulation of an OLED device can be formed.

In the following the invention will be explained in more detail by figures.

Figures 1A to 1C show one embodiment of the inventive method in a cross-sectional view.

Figure 2 shows a cross-section of an OLED device produced according to one embodiment of the method of the invention.

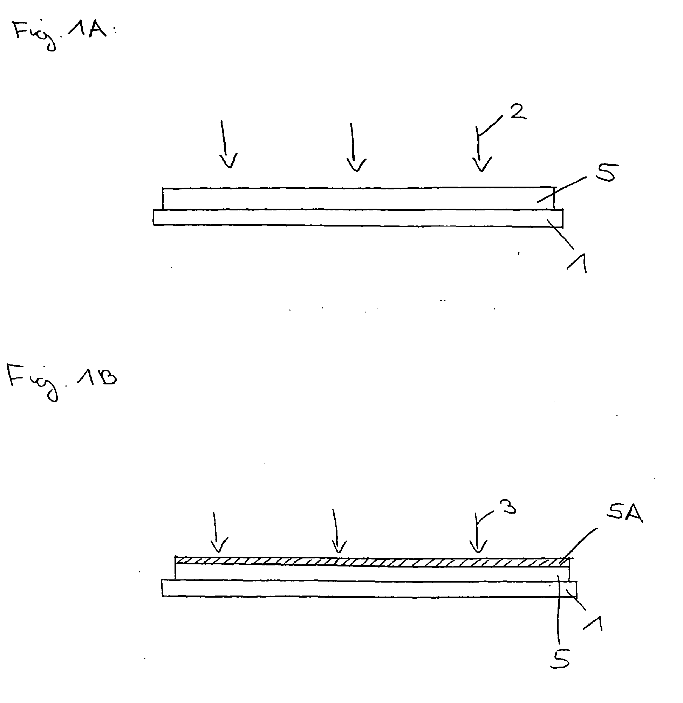

Figure 1A shows a first ceramic barrier layer 5 which was formed during step A) on a substrate 1. The arrows 2 denote the formation of the first ceramic barrier layer 5.

Figure 1B is a cross-sectional view of the arrangement during step B) of the method of the invention. During this step B) the surface 5A of the first ceramic barrier layer 5 is modified by chemical or mechanical modification or by introduction of nucleation promoting material in order to introduce new nucleation sites. The arrows 3 denote the direction of the modification in step B). It is also possible to modify just parts of the surface of the first layer and not a continuous layer as shown in Fig. 1B.

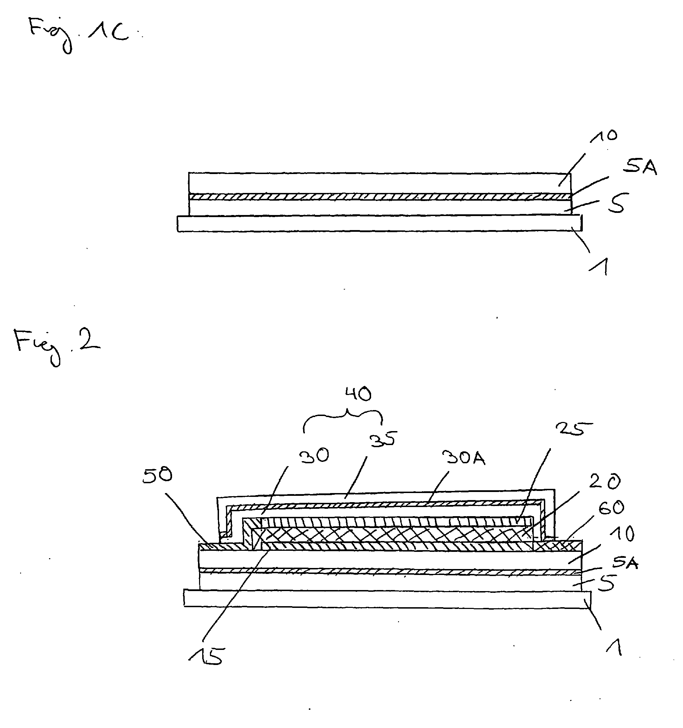

Figure 1C shows the arrangement of the substrate 1, the first ceramic layer 5 and the second ceramic layer 10 after step C) of the method of the invention. The second ceramic layer 10 was deposited on the modified surface 5A of the first ceramic layer 5. The new nucleation sites of the surface 5a differ from the morphology of the areas of the first ceramic layer 5, which are located below the surface 5A. Therefore the second layer 10 can be grown on the first ceramic layer with independent nucleation and different grain boundaries.

Figure 2 is a cross-sectional view of an OLED device formed by a method of the invention. The electrical, functional stack of the OLED device comprises at least one organic functional layer 20 inserted between a first electrically conductive layer 15 and a second electrically conductive layer 25. The electrical, functional stack is formed on a barrier arrangement consisting of the polymeric substrate 1, the first ceramic barrier layer 5 and the second ceramic barrier layer 10, which was deposited on the modified surface 5A of the first ceramic layer using new nucleation sites. An encapsulation 40 consisting of the third ceramic barrier layer 30 and the fourth ceramic barrier layer 35 is formed on top of the electrical, functional stack of the OLED device, sealing the electrical, functional stack of the device from the environment. Contact pads 50, 60, which are connected to the first 15 and the second electrically conductive layer 25 are present to enable an electrical connection to the OLED. After the formation of the third ceramic barrier layer 30 the surface 30A of this ceramic barrier layer was also modified to introduce new nucleation sites. Subsequently the fourth ceramic barrier layer was formed with independent nucleation sites on top of the third ceramic barrier layer. Therefore the method of the invention can provide an OLED device with enhanced lifetime by means of a tight encapsulation.

## Claims

1. A method for forming an arrangement of two ceramic barrier layers (5, 10) on a polymeric substrate (1) comprising the subsequent steps of:
A) applying a first ceramic barrier layer (5) on the substrate (1),
B) modifying the surface (5A) of the first barrier layer (5) to introduce new nucleation sites on the surface of this first layer,
C) forming a second ceramic barrier layer (10) on the first barrier layer (5) using the new nucleation sites.

2. The method according to the previous claim,
- wherein step B) comprises at least one of the following modification methods:
- chemical surface modification, mechanical surface modification and application of nucleation promoting material on the surface of the first layer.

3. The method according to one of the previous claims,
- wherein step B) comprises chemical surface modification, being selected from a group consisting of the following methods:
- acid treatment, base treatment, exposure to water vapour, plasma treatment and ozone treatment.

4. The method according to one of the claims 1 and 2,
- wherein step B) comprises mechanical surface modification, said modification being selected from a group consisting of the following methods:
- ion milling, nanogrinding, melting of surface by laser and tempering.

5. The method according to one of claims 1 and 2,
- wherein step B) comprises application of a nucleation promoting material, the material being selecting from a group of metals, metalnitrides and metaloxides, wherein the material has a critical nucleus of one atom or molecule.

6. The method according to the previous claim, wherein the nucleation promoting material is selected from the following materials:
- Ta, Cr, W, Mo, Nb, Ti, TaN, TiN, Ta₂O₅ and TiO₂.

7. The method according to one of the previous claims,
- wherein a ceramic material is used for the first and second barrier layer, which is selected from metalnitrides, metaloxides and metaloxynitrides.

8. The method according to the previous claim,
- wherein the metal is selected from Al or Si.

9. The method according to one of the previous claims,
- wherein in step C) the second barrier layer (10) is formed by CVD or PVD.

10. The method according to one of the previous claims,
- wherein in step A) the first barrier layer (5) is applied by laminating, printing, sputtering, spraying, CVD or PVD.

11. The method according to one of the previous claims,
- wherein a flexible, transparent substrate (1) is used.

12. The method according to one of the previous claims,
- wherein after step C) at least one third barrier layer is formed on the second barrier layer by repeating the steps B) and C) for the formation of the third barrier layer.

13. The method according to one of the previous claims,
- wherein in steps A) and C) the first (5) and second (10) barrier layers are formed in a thickness of 1 to 250 nm.

14. The method according to one of the previous claims, further comprising steps to form an organic electrical device,
- wherein after step C) an organic, functional layer is formed on the second barrier layer.

15. The method according to one of the claims 1 to 13, further comprising subsequent steps to form an OLED:
D) forming a first electrically conductive layer (15) on the second barrier layer (10) after step C),
E) forming a functional, organic layer (20) on the first electrically conductive layer (15),
F) forming a second electrically conductive layer (25) on the functional, organic layer (20).

16. The method for forming an OLED, according to one of the claims 14 and 15, further comprising:
G) forming an encapsulation (40) over the second electrically conductive layer (25), sealing the OLED.

17. The method according to the previous claim,
- wherein step G) further comprises:
G1) forming a fourth ceramic barrier layer (30) over the second, electrically conductive layer (25),
G2) subsequently modifying the surface (30A) of the fourth barrier layer (30) to introduce new nucleation sites on the surface of this fourth layer,
G3) forming a fifth ceramic barrier layer (35) on the fourth barrier layer.

## Patentansprüche

1. Verfahren zum Ausbilden einer Anordnung aus zwei Keramikbarriereschichten (5, 10) auf einem Polymersubstrat (1), umfassend die aufeinanderfolgenden Schritte:
A) Auftragen einer ersten Keramikbarriereschicht (5) auf dem Substrat (1),
B) Modifizieren der Oberfläche (5A) der ersten Barriereschicht (5), um neue Kristallisationszentren auf der Oberfläche dieser ersten Schicht einzuführen,
C) Ausbilden einer zweiten Keramikbarriereschicht (10) auf der ersten Barriereschicht (5) unter Verwendung der neuen Kristallisationszentren.

2. Verfahren nach dem vorhergehenden Anspruch,
- wobei Schritt B) mindestens eines der folgenden Modifikationsverfahren umfasst:
- chemische Oberflächenmodifikation, mechanische Oberflächenmodifikation und Auftragen eines kristallisationsfördernden Materials auf der Oberfläche der ersten Schicht.

3. Verfahren nach einem der vorhergehenden Ansprüche,
- wobei Schritt B) eine chemische Oberflächenmodifikation umfasst, ausgewählt aus einer Gruppe bestehend aus den folgenden Verfahren:
- Säurebehandlung, Basisbehandlung, Wasserdampf-Exposition, Plasmabehandlung und Ozonbehandlung.

4. Verfahren nach einem der Ansprüche 1 und 2,
- wobei Schritt B) eine mechanische Oberflächenmodifikation umfasst, wobei die Modifikation ausgewählt ist aus einer Gruppe bestehend aus den folgenden Verfahren:
- Ionenfräsen, Nanoschleifen, Schmelzen der Oberfläche durch Laser und Tempern.

5. Verfahren nach einem der Ansprüche 1 und 2,
- wobei Schritt B) das Auftragen eines kristallisationsfördernden Materials umfasst, wobei das Material ausgewählt ist aus einer Gruppe von Metallen, Metallnitriden und Metalloxiden, wobei das Material einen kritischen Keim in Form eines Atoms oder Moleküls aufweist.

6. Verfahren nach dem vorhergehenden Anspruch, wobei das kristallisationsfördernde Material ausgewählt ist aus den folgenden Materialien:
- Ta, Cr, W, Mo, Nb, Ti, TaN, TiN, Ta₂O₅ und TiO₂.

7. Verfahren nach einem der vorhergehenden Ansprüche,
- wobei ein Keramikmaterial für die erste und zweite Barriereschicht verwendet wird, das ausgewählt ist aus Metallnitriden, Metalloxiden und Metalloxynitriden.

8. Verfahren nach dem vorhergehenden Anspruch,
- wobei das Material aus A1 oder Si ausgewählt ist.

9. Verfahren nach einem der vorhergehenden Ansprüche,
- wobei im Schritt C) die zweite Barriereschicht (10) durch CVD oder PVD ausgebildet wird.

10. Verfahren nach einem der vorhergehenden Ansprüche,
- wobei im Schritt A) die erste Barriereschicht (5) durch Laminieren, Drucken, Sputtern, Sprühen, CVD oder PVD aufgetragen wird.

11. Verfahren nach einem der vorhergehenden Ansprüche,
- wobei ein flexibles transparentes Substrat (1) verwendet wird.

12. Verfahren nach einem der vorhergehenden Ansprüche,
- wobei nach Schritt C) mindestens eine dritte Barriereschicht auf der zweiten Barriereschicht ausgebildet wird durch Wiederholen der Schritte B) und C) für die Ausbildung der dritten Barriereschicht.

13. Verfahren nach einem der vorhergehenden Ansprüche,
- wobei in den Schritten A) und C) die erste (5) und die zweite (10) Barriereschicht mit einer Dicke von 1 bis 250 nm ausgebildet werden.

14. Verfahren nach einem der vorhergehenden Ansprüche, weiterhin umfassend Schritte zum Ausbilden eines organischen elektrischen Bauelements,
- wobei nach Schritt C) eine organische Funktionsschicht auf der zweiten Barriereschicht ausgebildet wird.

15. Verfahren nach einem der Ansprüche 1 bis 13, weiterhin umfassend aufeinanderfolgende Schritte zum Ausbilden einer OLED:
D) Ausbilden einer ersten elektrisch leitenden Schicht (15) auf der zweiten Barriereschicht (10) nach Schritt C),
E) Ausbilden einer organischen Funktionsschicht (20) auf der ersten elektrisch leitenden Schicht (15),
F) Ausbilden einer zweiten elektrisch leitenden Schicht (25) auf der organischen Funktionsschicht (20) .

16. Verfahren zum Ausbilden einer OLED nach Anspruch 14 oder 15, das weiterhin Folgendes umfasst:
G) Ausbilden einer Verkapselung (40) über der zweiten elektrisch leitenden Schicht (25), wodurch die OLED versiegelt wird.

17. Verfahren nach dem vorhergehenden Anspruch,
- wobei Schritt G) weiterhin Folgendes umfasst:
G1) Ausbilden einer vierten Keramikbarriereschicht (30) über der zweiten elektrisch leitenden Schicht (25) ,
G2) danach Modifizieren der Oberfläche (30A) der vierten Barriereschicht (30), um neue Kristallisationszentren auf der Oberfläche dieser vierten Schicht einzuführen,
G3) Ausbilden einer fünften Keramikbarriereschicht (35) auf der vierten Barriereschicht.

## Revendications

1. Procédé pour former une structure de couches barrières en céramique (5, 10) sur un substrat polymère (1) comprenant les étapes suivantes :
A) appliquer une première couche barrière en céramique (5) sur le substrat (1),
B) modifier la surface (5A) de la première couche barrière (5) pour introduire de nouveaux sites de nucléation sur la surface de cette première couche,
C) former une deuxième couche barrière en céramique (10) sur la première couche barrière (5) en utilisant les nouveaux sites de nucléation.

2. Procédé selon la revendication précédente,
- dans lequel l'étape B) comprend l'un au moins des procédés de modification suivantes :
- modification chimique de la surface, modification mécanique de la surface, et application d'un matériau favorisant la nucléation sur la surface de la première couche.

3. Procédé selon l'une des revendications précédentes,
- dans lequel l'étape B) comprend une modification chimique de la surface choisie dans un groupe constitué par les procédés suivantes :
- traitement acide, traitement basique, exposition à la vapeur d'eau, traitement par plasma, et traitement à l'ozone.

4. Procédé selon l'une des revendications 1 et 2,
- dans lequel l'étape B) comprend une modification mécanique de la surface, ladite modification étant choisie dans un groupe constitué par les procédés suivantes :
- gravure ionique, nanobroyage, fusion de surface par laser, et revenu.

5. Procédé selon l'une des revendications 1 et 2,
- dans lequel l'étape B) comprend l'application d'un matériau favorisant la nucléation, le matériau étant choisi dans un groupe de métaux, de nitrures métalliques et d'oxydes métalliques, le matériau ayant un noyau critique d'un atome ou d'une molécule.

6. Procédé selon la revendication précédente, dans lequel le matériau favorisant la nucléation est choisi parmi les matériaux suivantes :
- Ta, Cr, W, Mo, Nb, Ti, TaN, TiN, Ta₂O₅ et TiO₂.

7. Procédé selon l'une des revendications précédentes,
- dans lequel un matériau céramique est utilisé pour la première et la deuxième couche barrière, lequel est choisi parmi les nitrures métalliques, les oxydes métalliques et les oxynitrures métalliques.

8. Procédé selon la revendication précédente,
- dans lequel le métal est choisi parmi Al et Si.

9. Procédé selon l'une des revendications précédentes,
- dans lequel, à l'étape C), la deuxième couche barrière (10) est formée par CVD ou PVD.

10. Procédé selon l'une des revendications précédentes,
- dans lequel, à l'étape A), la première couche barrière (5) est appliquée par laminage, impression, pulvérisation cathodique, pulvérisation, CVD ou PVD.

11. Procédé selon l'une des revendications précédentes,
- dans lequel un substrat flexible, transparent (1) est utilisé.

12. Procédé selon l'une des revendications précédentes,
- dans lequel, après l'étape C), au moins une troisième couche barrière est formée sur la deuxième couche barrière en répétant les étapes B) et C) pour la formation de la troisième couche barrière.

13. Procédé selon l'une des revendications précédentes,
- dans lequel, aux étapes A) et C), la première couche barrière (5) et la deuxième couche barrière (10) sont formées dans une épaisseur de 1 à 250 nm.

14. Procédé selon l'une des revendications précédentes, comprenant en outre des étapes pour former un dispositif électrique organique,
dans lequel, après l'étape C), une couche fonctionnelle organique est formée sur la deuxième couche barrière.

15. Procédé selon l'une des revendications 1 à 13, comprenant en outre les étapes suivantes pour former une OLED :
D) former une première couche électriquement conductrice (15) sur la deuxième couche barrière (10) après l'étape C),
E) former une couche fonctionnelle organique (20) sur la première couche électriquement conductrice (15),
F) former une deuxième couche électriquement conductrice (25) sur la couche fonctionnelle organique (20) .

16. Procédé pour former une OLED, selon l'une des revendications 14 et 15, comprenant en outre :
G) la formation d'une encapsulation (40) par-dessus la deuxième couche électriquement conductrice (25) pour sceller l'OLED.

17. Procédé selon la revendication précédente,
- dans lequel l'étape G) comprend en outre :
G1) la formation d'une quatrième couche barrière en céramique (30) sur la deuxième couche électriquement conductrice (25),
G2) la modification consécutive de la surface (30A) de la quatrième couche barrière (30) pour introduire de nouveaux sites de nucléation sur la surface de cette quatrième couche,
G3) la formation d'une cinquième couche barrière en céramique (35) sur la quatrième couche barrière.
